# EUROPEAN PATENT SPECIFICATION

(11) **EP 3 341 345 B1**
(45) Date of publication and mention of the grant of the patent: **26.07.2023**
(21) Application number: 16819915.6
(22) Date of filing: 21.12.2016
(51) Int. Cl.: C04B 37/02, H01L 21/02

(54) **THICK-FILM PASTE MEDIATED CERAMICS BONDED WITH METAL OR METAL HYBRID FOILS**
DURCH DICKSCHICHTPASTE VERMITTELTE, MIT METALL- ODER METALLHYBRIDFOLIEN VERBUNDENE KERAMIK
CÉRAMIQUES À MÉDIATION DE PÂTE POUR COUCHES ÉPAISSES LIÉES À DES FEUILLES EN HYBRIDES DE MÉTAL OU EN MÉTAL

(30) Priority: 22.12.2015 EP 15201817
(43) Date of publication of application: 04.07.2018
(73) Proprietor: Heraeus Deutschland GmbH & Co. KG, 63450 Hanau (DE)
(72) Inventor: GUNDEL, Paul, 60594 Frankfurt (DE); MIRIC, Anton, 63755 Alzenau (DE); BAWOHL, Melanie, 69509 Mörlenbach (DE); ZIER, Gabriel, 92670 Windischeschenbach (DE); HERBST, Kai, 91056 Erlangen (DE)
(74) Representative: Gille Hrabal Partnerschaftsgesellschaft mbB Patentanwälte
(86) International application number: PCT/EP2016/082161
(87) International publication number: WO 2017/108939

(56) References cited:
- DE-A1-102010 025 313
- US-A- 4 172 919
- US-A- 4 323 483
- US-A1- 2012 107 631
- US-A1- 2014 126 155

## Description

The present invention relates to a process for preparing a ceramic substrate bonded with a metal foil via a thick-film layer.

In the field of power microelectronics applications in automotive, in particular for electric vehicles or hybrid vehicles, the use of electronic circuits with a high current carrying capacity and high durability are a high demand. For this purpose, the use of a highly conductive material with a high current carrying capacity, such as copper, is necessary. At the same time, the respective material should have a high capacity of heat dissipation (heat removal). Moreover, it is necessary that the respective material allow a suitable connection via a bond wire, has a good solderability, and should have the possibility of an oxidation protection by currentless plattings.

In the DBC technology, a copper foil is bonded onto a ceramic substrate with a eutectic melt. This process technology suffers from some disadvantages, such as a high amount of rejects, the creation of cavities between the ceramic substrate and the copper foil and the relatively low resistance against temperature changes (which leads to a delamination after some thermic cycles). A respective technology is described, for example, in DE 10 2010 025 313 A in which a mixture of the metal and an oxide of this metal is applied on a ceramic substrate which is then bonded via a DCB process.On the other hand, substrates, which are prepared based on the thick print technology, are also known. These substrates have the disadvantage of high production costs and low electronic and thermal conductivity caused by the porosity of the sintered layers.

Starting from this prior art situation, the present invention has the object to provide a metal-ceramic substrate which avoids the above-mentioned disadvantages.

In a first aspect, which is according to the invention, this object is solved by a process for preparing a structured metal-ceramic substrate, characterized by the following process steps:
(1.1) applying of a thick-film paste containing Cu as a metal onto a ceramic substrate:
(1.1a) sintering the thick-film paste at a temperature below 1025 °C;
(1.2) applying of a metal foil onto the thick-film layer of the ceramic substrate; and
(1.3) bonding of the metal foil with the ceramic substrate via the thick-film layer, wherein the thick-film paste comprises 70 to less than 92 wt.-% copper based on the total weight of the thick-film paste.

In a second aspect, which is not according to the invention, the underlying object is solved by a metal-ceramic substrate, comprising
(a) a ceramic substrate and, provided thereon,
(b) a metal-containing thick-film layer, and, provided thereon;
(c) a metal foil.

According to the present invention, it has been found out that based on the thick-film technology it is possible to provide a substrate for use in the field of power electronics in which a metal foil is bonded via a thick-film paste of a metal onto a ceramic substrate (such as Al₂O₃ ceramic, AIN ceramic or Si₃N₄ ceramic). The resulting metal-ceramic-substrates have a high conductivity and durability and can be produced with reduced costs.

At first, the above-mentioned process for preparing a structured metal-ceramic substrate is described.

### First embodiment of the claimed process

In the process according to the first embodiment of the present invention, the thick-film paste is applied onto the ceramic substrate in the first process step.

### First aspect: Discontinuous application of the thick-film paste

In a first aspect of the claimed process, the thick-film paste can be applied onto the ceramic substrate discontinuously such that the thick-film paste is only applied on those parts of the ceramic substrate, which correspond to an intended electronic circuit of the final metal-ceramic substrate.

In this first aspect, the metal foil may be applied, thereafter, continuously over the whole thick-film layer of the ceramic substrate. After that, the metal foil is bonded with the ceramic substrate and then structured, for example by etching.

In this first aspect, the metal foil may also be applied discontinuously over the thick-film layer only on those parts of the ceramic substrate on which the thick-film paste is applied.

### Second aspect: Continuous application of the thick-film paste

In a further second aspect of the process according to the present invention, the thick-film paste is applied continuously onto the ceramic substrate.

In this second aspect, the metal foil may be applied continuously over the whole thick-film layer of the ceramic substrate and the metal foil and the thick-film layer are structured, for example, by etching after bonding.

In this second aspect, the metal foil may also be applied discontinuously only on those parts of the ceramic substrate which correspond to an intended electronic circuit of the final metal-ceramic substrate. In this case, the thick-film layer is structured, for example, by etching after bonding.

After applying the thick-film paste onto the ceramic substrate, the thick-film paste may be air-dried prior to applying the metal foil onto the thick-film layer.

After applying the thick-film paste onto the ceramic substrate, the thick-film paste is sintered at a temperature below 1025 °C orior to applying the metal foil. Preferably, the sintering process is carried out by a temperature in the range of from 300 to 1025 °C, more preferably in the range of from 600 to 1025 °C, more preferably in the range of from 900 to 1025 °C, more preferably in the range of from 900 to less then 1025 °C, more preferably in the range of from 900 to 1000 °C. This temperature for the sintering process does in particular not provide a bonding of the thick-film paste and the substrate via a DCB process, but provides almost a continuously coating on the ceramic substrate by the known thick-film technology. Accordingly, this process step of sintering distinguishes the process according to the present invention from, for example, the process described in DE 10 2010 025 313 A in which the mixture of the metal and the oxide of the metal is bonded to the ceramic substrate at a higher temperature and under DCB conditions. Such DCB conditions (in particular the required temperature) are not applied doing the sintering process in the process according to the present invention.After applying the thick-film paste onto the ceramic substrate, the thick-film paste may also be air-dried and sintered prior to applying the metal foil onto the thick-film layer. The sintering conditions are as described above.

The sintering process of the applied thick-film paste is usually carried out under an inert atmosphere, such as a nitrogen atmosphere.

Second embodiment, which is not according to the invention In a further modified process for preparing a structured metal-ceramic substrate according to the second embodiment, the modified process comprises the following process steps:
(2.1) applying of a thick-film paste onto a metal foil;
(2.2) applying of a ceramic substrate onto the thick-film layer of the metal foil; and
(2.3) bonding the metal foil with the ceramic substrate via the thick-film layer.

In this modified process, the thick-film paste may be coated onto the metal foil substrate by screen printing.

After applying the thick-film paste onto the metal foil, the thick-film paste may be air-dried prior to applying the metal foil onto the ceramic.

In the modified process, the metal foil and the thick-film paste are structured by etching before or after bonding the metal foil onto the ceramic substrate via the thick-film layer.

The following explanations are given for both embodiments:

The thick-film paste may be applied onto the substrate or the metal foil by multilayer printing. If a process step of multilayer coating is applied and the thick-film paste is applied onto a substrate, the first coating of the multilayer coating may be provided with lines for contacts.

In both processes for preparing a structured metal-ceramic substrate, i.e. the normal process and the modified process, the bonding steps (1.3) and/or (2.3) are carried out by firing. Usually, the firing is carried out at a temperature of between 750 and 1100 °C, more preferably of between 800 and 1085 °C. In these bonding steps the metal foil is bonded via the thick-film paste to the substrate basically not by applying the DCB process since the metal foil is in contact with the layer provided by the thick-film paste and not with the substrate.

The metal foil may be oxidized before bonding to the ceramic substrate via the thick-film layer in both embodiments of the processes according to the present invention. In another embodiment of the present invention the metal foil is not oxidized before bonding to the ceramic substrate via the thick-film layer.

In a further modification of the claimed processes according to both embodiments, the thick-film layer may be oxidized before bonding of the metal foil onto the ceramic substrate. In another embodiment of the present invention the thick-film layer is not oxidized before bonding of the metal foil onto the ceramic substrate.

The process steps (1.3) and/or (2.3) of bonding the metal foil onto the ceramic substrate provided with the thick-film layer may be carried out under pressure.

In both embodiments according to the present invention, the metal foil is preferably a copper foil.

In a further aspect of the present invention, the ceramic may be selected from the group consisting of an Al₂O₃ ceramic, an AIN ceramic and a Si₃N₄ ceramic.

### Thick-film paste

In the following, the thick-film paste, which can be used in the process according to both embodiments, is described in more detail:

The thick-film paste used in the process according to the present invention comprises copper as a metal and optionally Bi₂O₃.

The thick-film paste comprises 70 to less than 92 wt.-% copper, most preferably 75 to 90 wt.-% copper, each based on the total weight of the thick-film paste.

The thick-film paste comprises preferably 0 to 50 wt.-% Bi₂O₃, more preferably 1 to 20 wt.-% Bi₂O₃, most preferably 2 to 15 wt.-% Bi₂O₃, each based on the total weight of the thick-film paste.

The copper particles used in the thick-film paste have a median diameter (d₅₀) preferably of between 0.1 to 20 µm, more preferably of between 1 and 10 µm, most preferably of between 2 and 7 µm.

The Bi₂O₃ particles used optionally in the thick-film paste have a median diameter (d₅₀) preferably of less than 100 µm, more preferably of less than 20 µm, most preferably of less than 10 µm.

In a further embodiment of the present invention, the metal-containing thick-film paste may comprise copper and a glass component.

The amount of copper in the thick-film paste in case of a simultaneous use of a glass component might be as defined above, i.e. preferably in an amount of from 40 to 92 wt.-%, more preferably 40 to less than 92 wt.-% copper, more preferably in an amount of from 70 to less than 92 wt.-% copper, most preferably in an amount of from 75 to 90 wt.-% copper, each based on the total weight of the thick-film paste.

In the case of use of a glass component in the thick-film paste, the thick-film paste comprises preferably of from 0 to 50 wt.-%, more preferably 1 to 20 wt.-%, most preferably 2 to 15 wt.- %, of the glass component, each based on the total weight of the thick-film paste.

In the case of use of a glass component in the thick-film paste, the copper particles may have the same median diameter (d₅₀) as already mentioned above, i.e. preferably of between 0.1 to 20 µm, more preferably of between 1 and 10 µm, most preferably of between 2 and 7 µm.

In the case of use of a glass component in the thick-film paste, the glass component particles may have a median diameter (d₅₀) of less than 100 µm, more preferably less than 20 µm, most preferably less than 10 µm.

The metal-containing thick-film paste, preferably on the basis of copper, may comprise - besides the glass component and Bi₂O₃ - further components, selected from the group consisting of PbO, TeO₂, Bi₂O₃, ZnO, B₂O₃, Al₂O₃, TiO₂, CaO, K₂O, MgO, Na₂O, ZrO₂, and Li₂O.

After applying the thick-film paste either onto the ceramic substrate or onto the metal foil, the layer thickness is preferably of from 5 to 150 µm, more preferably of from 20 to 125 µm, most preferably of from 30 to 100 µm.

In a preferred embodiment of the present invention, the amount of copper oxide in the thick-film paste is less than 2 wt.-%, more preferably less than 1.9 wt.-%, more preferably less than 1.8 wt.-%, more preferably less than 1.5 wt.-%.

### Metal-ceramic substrate

In a further aspect, which is not according to the invention, the present invention relates to a metal-ceramic substrate, comprising
(a) a ceramic substrate and, provided thereon,
(b) a metal-containing thick-film layer, and, provided thereon,
(c) a metal foil.

The metal foil and/or the metal-containing thick-film layer may be structured.

The thick-film layer, provided onto the ceramic substrate, comprises preferably copper as a metal and optionally Bi₂O₃.

The thick-film paste comprises preferably 40 to 92 wt.-% copper, more preferably 40 to less than 92 wt.-% copper,more preferably 70 to less than 92 wt.-% copper, most preferably 75 to 90 wt.-% copper, each based on the total weight of the thick-film paste.

The thick-film paste comprises preferably 0 to 50 wt.-% Bi₂O₃, more preferably 1 to 20 wt.-% Bi₂O₃, most preferably 2 to 15 wt.-% Bi₂O₃, each based on the total weight of the thick-film paste.

The copper particles used in the thick-film paste have a median diameter (d₅₀) preferably of between 0.1 to 20 µm, more preferably of between 1 and 10 µm, most preferably of between 2 and 7 µm.

The Bi₂O₃ particles used optionally in the thick-film paste have a median diameter (d₅₀) preferably of less than 100 µm, more preferably of less than 20 µm, most preferably of less than 10 µm.

In a further aspect, the metal-containing thick-film paste may comprise copper and a glass component.

The amount of copper in the thick-film paste in case of a simultaneous use of a glass component might be as defined above, i.e. preferably in an amount of from 40 to 92 wt.-%, more preferably in an amount of from 70 to 92 wt.-% copper, most preferably in an amount of from 75 to 90 wt.-% copper, each based on the total weight of the thick-film paste.

In the case of use of a glass component in the thick-film paste, the thick-film paste comprises preferably of from 0 to 50 wt.-%, more preferably 1 to 20 wt.-%, most preferably 2 to 15 wt.- %, of the glass component, each based on the total weight of the thick-film paste.

In the case of use of a glass component in the thick-film paste, the copper particles may have the same median diameter (d₅₀) as already mentioned above, i.e. preferably of between 0.1 to 20 µm, more preferably of between 1 and 10 µm, most preferably of between 2 and 7 µm.

In the case of use of a glass component in the thick-film paste, the glass component particles have may have a median diameter (d50) of less than 100 µm, more preferably less than 20 µm, most preferably less than 10 µm.

The metal-containing thick-film paste may comprise - besides the glass component and Bi₂O₃ - further components, selected from the group consisting of PbO, TeO₂, Bi₂O₃, ZnO, B₂O₃, Al₂O₃, TiO₂, CaO, K₂O, MgO, Na₂O, ZrO₂, and Li₂O.

The layer thickness of the thick-film paste is preferably 10 to 150 µm, more preferably 20 to 125 µm, most preferably 30 to 100 µm.

The metal foil is preferably a copper foil.

In a further aspect, the ceramic may be selected from the group consisting of an Al₂O₃ ceramic, an AIN ceramic and a Si₃N₄ ceramic.

The metal-ceramic substrate may preferably be prepared according to the above-mentioned process.

In a further aspect, the present invention relates to the use of the above-mentioned thick-film paste for preparing a metal-ceramic substrate as intermediate layer between a ceramic substrate and a metal foil according to the first embodiment.

The above-mentioned thick-film is used in order to avoid the delamination of the resulting system of a substrate and a metal foil during operation by thermal cycles.

The thick-film layer, provided onto the ceramic substrate, comprises preferably copper as a metal and optionally Bi₂O₃.

The thick-film paste comprises preferably 40 to 92 wt.-% copper, more preferably 40 to less than 92 wt.-% copper, more preferably 70 to less than 92 wt.-% copper, most preferably 75 to 90 wt.-% copper, each based on the total weight of the thick-film paste.

The thick-film paste comprises preferably 0 to 50 wt.-% Bi₂O₃, more preferably 1 to 20 wt.-% Bi₂O₃, most preferably 2 to 15 wt.-% Bi₂O₃, each based on the total weight of the thick-film paste.

The copper particles used in the thick-film paste have a median diameter (d₅₀) preferably of between 0.1 to 20 µm, more preferably of between 1 and 10 µm, most preferably of between 2 and 7 µm.

The Bi₂O₃ particles used optionally in the thick-film paste have a median diameter (d₅₀) preferably of less than 100 µm, more preferably of less than 20 µm, most preferably of less than 10 µm.

In a further aspect, the metal-containing thick-film paste may comprise copper and a glass component.

The amount of copper in the thick-film paste in case of a simultaneous use of a glass component might be as defined above, i.e. preferably in an amount of from 40 to 92 wt.-%, more preferably in an amount of from 70 to 92 wt.-% copper, most preferably in an amount of from 75 to 90 wt.-% copper, each based on the total weight of the thick-film paste.

In the case of use of a glass component in the thick-film paste, the thick-film paste comprises preferably of from 0 to 50 wt.-%, more preferably 1 to 20 wt.-%, most preferably 2 to 15 wt.- %, of the glass component, each based on the total weight of the thick-film paste.

In the case of use of a glass component in the thick-film paste, the copper particles may have the same median diameter (d₅₀) as already mentioned above, i.e. preferably of between 0.1 to 20 µm, more preferably of between 1 and 10 µm, most preferably of between 2 and 7 µm.

In the case of use of a glass component in the thick-film paste, the glass component particles have may have a median diameter (d₅₀) of less than 100 µm, more preferably less than 20 µm, most preferably less than 10 µm.

The metal-containing thick-film paste may comprise - besides the glass component and Bi₂O₃ - further components, selected from the group consisting of PbO, TeO₂, Bi₂O₃, ZnO, B₂O₃, Al₂O₃, TiO₂, CaO, K₂O, MgO, Na₂O, ZrO₂, and Lᵢ2O.

The layer thickness of the thick-film paste is preferably 10 to 150 µm, more preferably 20 to 125 µm, most preferably 30 to 100 µm.

The metal foil is preferably a copper foil.

The present invention is described in more detail with regard to the following examples:
A thick-film paste material is prepared starting from the following glass composition (in wt.- %):

| Glass | d₅₀ (µm) | Tg (DSC, °C) | SiO₂ | ZnO | B₂O₃ | Al₂O₃ | TiO₂ | CaO | K₂O | MgO | Na₂O | ZrO₂ | Li₂O |
|---|---|---|---|---|---|---|---|---|---|---|---|---|---|
| A | 2,6 | 744 | 38 | 0.2 | 3.9 | 19.5 | 2.4 | 35.9 | 0.1 | 0 | 0 | 0.1 | 0 |
| B | 3,6 | 677 | 27.3 | 3.9 | 10.5 | 24.7 | 3.5 | 25.9 | 0 | 3.21 | 0.8 | 0 | 0 |
| C | 2,8 | 584.6 | 61.2 | 0.5 | 9.0 | 3.3 | 6.4 | 8.8 | 6.5 | 0.5 | 2.8 | 0 | 0.6 |

### Vehicle formulation

| Texanol [wt%] | Butyl diglyme | Acrylic resin |
|---|---|---|
| 43 | 23 | 34 |

### Paste formulation

| Paste | Cu powder [wt%] (d₅₀ of 4.7 µm) | Glass type; [wt%] | Vehicle [wt%] | Bi₂O₃ [wt%] (d₅₀ of 4.3 µm) |
|---|---|---|---|---|
| A | 86 | A; 3 | 11 | - |
| B | 86 | B; 3 | 11 | - |
| C | 86 | C; 3 | 11 | - |
| D | 86 | - | 11 | 3 |

Starting from these paste formulations, a ceramic metal substrate was prepared by printing the pastes on a Al₂O₃ ceramic substrate in a thickness of 40 µm. The pastes were dried in an oven at 110 °C for 10 min and sintered at 950 °C for 10 minutes before a Cu foil with a thickness of 300 µm was applied onto the dried pastes and the composite was fired in an oven at 1040 °C for 150 min.

For comparison, a ceramic metal substrate was prepared starting from the same ceramic substrate and the same Cu foil as for the examples with pastes, but using a standard DCB process with a bonding temperature of 1063 °C for 240 min.

The finished metal ceramic substrates have been subject to thermal cycles (15 min at -40 °C, 15 sec. transfer time, 15 min at +150 °C). The test results can be seen in the following table.

| Metal ceramic substrate | Paste | # of thermal cycles before delamination |
|---|---|---|
| 1 | A | 1550 |
| 2 | B | 2470 |
| 3 | C | 3040 |
| 4 | D | 2850 |
| 5 | No paste, standard DCB process | 100 |

## Claims

1. A process for preparing a structured metal-ceramic substrate, **characterized by** the following process steps:
(1.1) applying of a thick-film paste containing Cu as a metal onto a ceramic substrate;
(1.1a) sintering the thick-film paste at a temperature below 1025°C;
(1.2) applying of a metal foil onto the thick-film layer of the ceramic substrate; and
(1.3) bonding of the metal foil with the ceramic substrate via the thick-film layer,
wherein the thick-film paste comprises 70 to less than 92 wt.-% copper based on the total weight of the thick-film paste.

2. The process according to claim 1, **characterized in that** the thick-film paste is applied continuously or discontinuously.

3. The process according to any one of claims 1 or 2, **characterized in that** the metal foil is applied continuously or discontinuously.

4. The process according to any one of claims 1 to 3, **characterized in that** the thick-film paste is coated onto the metal foil or the ceramic substrate by screen-printing.

5. The process according to claims 1 to 3, **characterized in that** the thick-film paste is applied onto the substrate by multilayer coating and a first coating of this multilayer coating is provided with lines for contacts.

6. The process according to any one of claims 1 to 5, **characterized in that** the metal foil and/or the thick-film layer is oxidized before bonding to the ceramic substrate.

7. The process according to any of claims 1 to 6, **characterized in that** the thick-film paste comprises copper as a metal and Bi₂O₃ or a glass material.

## Patentansprüche

1. Verfahren zur Herstellung eines strukturierten Metall-Keramik-Substrats, **gekennzeichnet durch** die folgenden Verfahrensschritte:
(1.1) Aufbringen einer Dickfilmpaste, die Cu als Metall enthält, auf ein Keramiksubstrat;
(1.1a) Sinterung der Dickfilmpaste bei einer Temperatur unter 1025 °C;
(1.2) Aufbringen einer Metallfolie auf die Dickfilmschicht des Keramiksubstrats; und
(1.3) Verbinden der Metallfolie mit dem Keramiksubstrat über die Dickfilmschicht,
wobei die Dickfilmpaste 70 bis weniger als 92 Gew.-% Kupfer, bezogen auf das Gesamtgewicht der Dickfilmpaste, enthält.

2. Verfahren nach Anspruch 1, **dadurch gekennzeichnet, dass** die Dickfilmpaste kontinuierlich oder diskontinuierlich aufgetragen wird.

3. Verfahren nach einem der Ansprüche 1 oder 2, **dadurch gekennzeichnet, dass** die Metallfolie kontinuierlich oder diskontinuierlich aufgebracht wird.

4. Verfahren nach einem der Ansprüche 1 bis 3, **dadurch gekennzeichnet, dass** die Dickfilmpaste im Siebdruckverfahren auf die Metallfolie oder das Keramiksubstrat aufgebracht wird.

5. Verfahren nach einem der Ansprüche 1 bis 3, **dadurch gekennzeichnet, dass** die Dickfilmpaste durch mehrlagige Beschichtung auf das Substrat aufgebracht wird und eine erste Schicht dieser mehrlagigen Beschichtung mit Kontaktlinien versehen wird.

6. Verfahren nach einem der Ansprüche 1 bis 5, **dadurch gekennzeichnet, dass** die Metallfolie und/oder die Dickfilmschicht vor dem Verbinden mit dem Keramiksubstrat oxidiert wird.

7. Verfahren nach einem der Ansprüche 1 bis 6, **dadurch gekennzeichnet, dass** die Dickfilmpaste Kupfer als Metall und Bi₂O₃ oder ein Glasmaterial enthält.

## Revendications

1. Procédé pour préparer un substrat structuré métallo-céramique, **caractérisé par** les étapes de procédé suivantes :
(1.1) application d'une pâte à film épais contenant du Cu en tant que métal sur un substrat céramique ;
(1.1a) frittage de la pâte à film épais à une température inférieure à 1025°C ;
(1.2) application d'une feuille métallique sur la couche film épais du substrat céramique ; et
(1.3) liaison de la feuille métallique avec le substrat céramique par la couche à film épais,
dans lequel la pâte à film épais comprend 70 à moins de 92 % en poids de cuivre par rapport au poids total de la pâte à film épais.

2. Procédé selon la revendication 1, **caractérisé en ce que** la pâte à film épais est appliquée de manière continue ou discontinue.

3. Procédé selon l'une quelconque des revendications 1 ou 2, **caractérisé en ce que** la feuille métallique est appliquée de manière continue ou discontinue.

4. Procédé selon l'une quelconque des revendications 1 à 3, **caractérisé en ce que** la pâte à film épais est revêtue sur la feuille métallique ou le substrat céramique par sérigraphie.

5. Le procédé selon les revendications 1 à 3, **caractérisé par** en ce que la pâte à film épais est appliquée sur le substrat par revêtement multicouche et qu'un premier revêtement de ce revêtement multicouche est fourni de lignes pour contacts.

6. Procédé selon l'une quelconque des revendications 1 à 5, **caractérisé en ce que** la feuille métallique et/ou la couche à film épais est oxydée avant d'être liée au substrat céramique.

7. Procédé selon l'une des revendications 1 à 6, **caractérisé en ce que** la pâte à film épais comprend du cuivre en tant que métal et du Bi₂O₃ ou un matériau en verre.
